Europäisches Patentamt

European Patent Office

Office européen des brevets

(11) Veröffentlichungsnummer: **0 131 295**
**B1**

(12) **EUROPÄISCHE PATENTSCHRIFT**

(45) Veröffentlichungstag der Patentschrift:
**28.10.87**

(51) Int. Cl.⁴: **G 03 C  1/68,** G 03 F  7/10

(21) Anmeldenummer: **84107960.1**

(22) Anmeldetag: **06.07.84**

(54) **Verfahren zur Stabilisierung von photopolymerisierbaren Mischungen.**

(30) Priorität: **08.07.83  DE 3324642**

(43) Veröffentlichungstag der Anmeldung:
**16.01.85 Patentblatt 85/3**

(45) Bekanntmachung des Hinweises auf die Patenterteilung:
**28.10.87 Patentblatt 87/44**

(84) Benannte Vertragsstaaten:
**DE FR GB NL**

(56) Entgegenhaltungen:
**EP - A - 0 021 829**
**EP - A - 0 064 564**
**US - A - 3 615 567**

(73) Patentinhaber: **BASF Aktiengesellschaft,**
**Carl-Bosch-Strasse 38, D-6700 Ludwigshafen (DE)**

(72) Erfinder: **Wallbillich, Guenter, Dr., Eichendorffallee 15,**
**D-6707 Schifferstadt (DE)**

## Beschreibung

Die Erfindung betrifft ein Verfahren zur Stabilisierung von photopolymerisierbaren wasserlöslichen oder wasserdispergierbaren Mischungen, im wesentlichen bestehend aus einem Basispolymerisat, mindestens einer polymerisierbaren ethylenisch ungesättigten Verbindung mindestens einem Photoinitiator und/oder Photosensibilisator gegen thermische Polymerisation.

Photopolymerisierbare Mischungen der genannten Art, welche durch die Einwirkung von Licht unlöslich werden, lassen sich bekanntermassen für die Herstellung von Druckplatten, Überzugsmaterialien, Photolacken und generell für die Fixierung, Reproduktion und Übertragung von Informationen einsetzen. Diese Mischungen müssen jedoch gegen eine spontane vorzeitige thermische Polymerisation, welche während der Verarbeitung, Lagerung oder des Transports eintreten kann, stabilisiert werden. Ein übliches Verfahren ist der Zusatz von Radikalfängern, Antioxydantien, Peroxidzerstörern, Wasserstoffakzeptoren und -donatoren, Elektronenakzeptoren und -donatoren und/oder Komplexbildnern. Auch Gase, wie z.B. Sauerstoff und Oxide des Stickstoffs können bei der Unterdrückung der spontanen Polymerisation von photopolymerisierbaren Mischungen eine wesentliche Rolle spielen. Im einzelnen sind eine Vielzahl von Verbindungen als geeignet beschrieben worden, wie z.B. phenolische Verbindungen, Hydrochinon und dessen Derivate, Amine, Nitrosamine, Nitro- und Nitrosoverbindungen, Hydroxylamine, N-Nitrosohydroxylaminderivate, Hydrazine, Harnstoff und dessen Derivate, Thioharnstoffe und dessen Derivate, Dithiocarbaminat, Pyridine, Chinoline, N-haltige Heterocyclen, Schwefel, Ascorbinsäure, Tocopherol, Methylenblau, Phosphine, Phosphorigsäureester und Komplexbildner wie Polyphosphor- und Polykieselsäuren und deren Salze, Nitrilotriessigsäure, EDT, Hydroxycarbonsäuren. Auch Kombinationen von zwei oder mehreren Verbindungen der genannten Art sind meist im Hinblick auf synergistische Effekte bekannt geworden. Diese Inhibitoren der thermischen Polymerisation haben jedoch oft den Nachteil, dass sie die Lichtempfindlichkeit vermindern, wenn sie auch voll wirksam sind, um die Stabilität der lichtempfindlichen Materialien zu verbessern. Bei der Auswahl der Stabilisatoren ist auch deren Farbe zu beachten, da Verfärbungserscheinungen bei der Lagerung und bei den Reaktionen im Zusammenhang mit der Verwendung der photopolymerisierbaren Mischungen störend sind. Dies gilt umso mehr, da die meisten Stabilisatoren und/oder ihre Folgeprodukte in dem für die Photopolymerisation wichtigen Wellenlängenbereich zwischen 300 und 500 nm nicht selten absorbieren.

Insbesondere im Zusammenhang mit der Verwendung photopolymerisierbarer Mischungen für die Speicherung, Reproduktion und Übertragung von Informationen müssen die angegebenen Nachteile bzw. Einschränkungen der bekannten Stabilisatoren sehr eingehend berücksichtigt werden. So hat sich in letzter Zeit auf dem vorstehend genannten Anwendungsgebiet die Notwendigkeit einer hohen Lichtempfindlichkeit sehr vergrössert. Die Verwendung der üblichen Inhibitoren der thermischen Polymerisation ergaben jedoch keine photopolymerisierbaren Mischungen, die einerseits eine hohe Empfindlichkeit ergaben und andererseits bei der praktischen Anwendung keine Schwierigkeiten aufkommen lassen. Gerade die komplex zusammengesetzten Mischungen, welche die gewünschte hohe Lichtempfindlichkeit aufweisen, beinhalten bereits eine vielfältige Zahl von Möglichkeiten, welche eine vorzeitige Polymerisation auslösen können. Ebenso erfordert die hohe Lichtempfindlichkeit eine möglichst knappe Dosierung der Stabilisatoren, deren Auswahl durch die Forderung nach Transparenz im die Polymerisation auslösenden Wellenlängenbereich dazu noch stark eingeschränkt ist.

Andererseits erfordert die Tendenz aus Umweltgründen photopolymerisierbare Mischungen ohne organische Lösungsmittelgehalte herzustellen, bzw. den Anteil organischer Lösungsmittel sehr stark zu verringern, die Entwicklung weitgehend neuer Systeme. Für diese neuen photopolymerisierbaren Mischungen eignen sich meist die vorbekannten Stabilisatoren nur sehr ungenügend. Dies trifft vor allem auch deshalb zu, weil hinsichtlich Empfindlichkeit und Auflösung, d.h. hohe Dichte der Wiedergabe, an die für die Informationsverarbeitung geeigneten photopolymerisierbaren Mischungen sehr hohe Anforderungen gestellt werden.

Um die Nachteile photopolymerisierbarer Mischungen und ihrer Folgeprodukte zu beheben, hat man verschiedentlich ihre Behandlung mit Halogeniden oder Polyhalogeniden, deren komplexe Anionen als Anlagerungsprodukte von freien Halogenen an Halogenidionen anzusehen sind, in Betracht gezogen.

So geht aus der US-A-3 615 567 die Behandlung photopolymerisierbarer Mischungen oder Schichten aus diesen Mischungen mit Chloriden oder Bromiden hervor. Dabei handelt es sich um die einfachen Salze wie etwa $CaCl_2 \cdot 2H_2O$ oder $ZnCl_2$, welche allgemein deshalb nicht als Polyhalogenide angesehen werden, weil sie keine komplexen Anionen enthalten, welche als die Anlagerungsprodukte von freien Halogenen an Halogenidionen anzusehen sind. Die genannte Massnahme bezweckt, den Farbkontrast zwischen den belichteten und unbelichteten Bereichen einer photopolymerisierbaren Druckplatte nach deren bildmässigen Belichtung zu erhöhen und hat keine Verbesserung der thermischen Stabilität zur Folge.

Die EP-A-0 021 829 beschreibt die Nachbehandlung der Oberfläche bildmässig belichteter und entwickelter, d.h. photopolymerisierter Flexodruckformen mit Lösungen von Jod in Perchlorethylen. Zwar mag man Perchlorethylen und verwandte Verbindungen formal als Polyhalogenide ansehen, üblicherweise werden sie aber als «poly- oder perhalogenierte Kohlenwasserstoffe» bezeichnet. Solche Verbindungen enthalten keine komplexen Anionen der genannten Art und sind somit keine Polyhalogenide.

Ausserdem ist aus der EP-A-0 021 829 auch ein entsprechendes Nachbehandlungsverfahren mit einer wässrigen KI.I$_2$-Lösung bekannt. Bei KI.I$_2$ handelt es sich zwar um ein Polyhalogenid, es wird indes hier zur Behandlung von unlöslichen photopolymerisierten Flexodruckformen und nicht zur Behandlung wasserlöslicher oder wasserdispergierbarer, photopolymerisierbarer Mischungen zum Zwecke ihrer Stabilisierung gegenüber der thermisch initiierten Polymerisation verwendet.

Aufgabe der vorliegenden Erfindung war es daher, ein Verfahren zur Stabilisierung von photopolymerisierbaren Mischungen gegen thermische Polymerisation bereitzustellen, wodurch sich photopolymerisierbare Mischungen erhalten lassen, welche bei hoher Lichtempfindlichkeit und hoher Auflösung, d.h. bei ausgezeichneten optischen Eigenschaften, die vorgenannten Nachteile nicht aufweisen.

Es wurde nun überraschend gefunden, dass sich photopolymerisierbare wasserlösliche oder wasserdispergierbare Mischungen, im wesentlichen aus einem Basispolymerisat, mindestens einer ethylenisch ungesättigten Verbindung und mindestens einem Photoinitiator und/oder Photosensibilisator bestehend, aufgabenmässig gegen thermische Polymerisation stabilisieren lassen, wenn das Basispolymerisat allein oder zusammen mit den anderen Komponenten der photopolymerisierbaren Mischung mit einem Halogen, einem Pseudohalogen oder einem Polyhalogenid, dessen komplexes Anion als das Anlagerungsprodukt von freiem Halogen an ein Halogenidion anzusehen ist, behandelt wird.

Besonders vorteilhaft lässt sich das erfindungsgemässe Verfahren in der Weise durchführen, dass das Basispolymerisat allein oder zusammen mit den anderen Komponenten der photopolymerisierbaren Mischung in Gegenwart von Wasser oder in wässriger Lösung bei einer Temperatur zwischen 20 und 100 °C mit einem Halogen, einem Pseudohalogen oder einem Polyhalogenid, dessen komplexes Anion als das Anlagerungsprodukt von freiem Halogen an ein Halogenidion anzusehen ist, behandelt wird.

Zweckmässigerweise wird die erfindungsgemässe Behandlung des Basispolymerisats mit dem Halogen oder Halogenäquivalent während einer halben Stunde bis zu mehreren Tagen mit einem im Rahmen der Herstellung bzw. Verarbeitung des photopolymerisierbaren Mischung ohnehin durchzuführenden Löse-, Misch- oder Dispergiervorgang verbunden.

Zur Durchführung des erfindungsgemässen Verfahrens eignen sich als Halogene die Elemente Chlor, Brom und Jod, wobei insbesondere Jod bevorzugt ist. Es können hierfür auch Pseudohalogene verwendet werden. Unter Pseudohalogene versteht man Moleküle, welche aus mindestens 2 elektronegativen Gruppen wie z.B. −CN, −OCN, − SCN oder −N$_3$ bestehen und welche den Halogenen in ihren physikalischen und chemischen Eigenschaften ähnlich sind. Des weiteren lassen sich für das erfindungsgemässe Verfahren Polyhalogenide verwenden, wobei dies sowohl anorganische als auch organische Polyhalogenide sein können. Die anorganischen Polyhalogenide weisen komplexe Anionen auf, welche sich durch Anlagerung von freiem Halogen an ein Halogenidion bilden. Sie bilden sich umso leichter und sind umso stabiler, je grösser das Atomgewicht des Halogens und je grösser das Atomvolumen des Kations sind. Für das vorliegende Verfahren eignet sich insbesondere das KJ.J$_2$. Organische Polyhalogenide sind in grosser Zahl dargestellt worden. Die meisten Stickstoffbasen sind imstande, Polyhalogenide, insbesondere Polyjodide zu bilden. Von den aromatischen Aminen und den aromatischen und aliphatischen Ammoniumbasen ergeben besonders die sekundären, tertiären und quaternären Verbindungen stabile Polyjodide. Als vorteilhaft für das erfindungsgemässe Stabilisierungsverfahren sei die Anlagerung von Jod an Polyvinylpyrrolidon genannt.

Die beim erfindungsgemässen Verfahren eingesetzten Mengen liegen je nach Art der geeigneten Halogen-abgebenden Verbindung zwischen 0,001 bis 1,0 Gew.-%, bezogen auf den Anteil an wasserfreier photopolymerisierbarer Mischung.

Bei den bevorzugten Substanzen wie dem Kaliumjodid-Jod beträgt die eingesetzte Menge insbesondere 0,002 bis 0,5 Gew.-% beim Polyvinylpyrrolidon-Jod zwischen 0,005 und 1,0 Gew.-%. Die Einwirkungsdauer beträgt dann zweckmässigerweise 3 bis 24 Stunden und die Temperatur liegt zwischen 40 bis 90 °C.

Die Zusammensetzung der photopolymerisierbaren wasserlöslichen oder wasserdispergierbaren Mischungen ist an sich bekannt. Als photoempfindliche Schicht von mindestens einem hydrophilen polymeren Bindemittel mit mindestens einem damit verträglichen photopolymerisierbaren ethylenisch ungesättigten Monomeren und einem Photoinitiator kommen beispielsweise Mischungen in Frage, wie sie u.a. in den britischen Patentschriften 786 119, 834 337, 835 849, 1 233 883, 1 251 475 oder 1 416 440 beschrieben sind.

Als geeignete Basispolymere haben sich insbesondere Vinylalkohol-Polymere mit −CH$_2$CH(OH)-Struktureinheiten in der Polymerhauptkette erwiesen sowie deren in Wasser lösliche oder dispergierbare Copolymerisate und Derivate, wie Ester, Ether oder Acetale. Besonders geeignet sind die bekannten verseiften Polyvinylester von aliphatischen Monocarbonsäuren mit 1 bis 4 C-Atomen, wie Polyvinylacetate oder Polyvinylpropionate, deren mittlerer Polymerisationsgrad 200 bis 3000 und insbesondere 250 bis 750, und deren Verseifungsgrad 65 bis etwa 100 und insbesondere 80 bis 88 Mol.-% beträgt. Auch Gemische von verseiften Vinylester-Polymeren oder -Copolymeren mit unterschiedlichem Polymerisationsgrad und/oder unterschiedlichem Verseifungsgrad können angewandt werden. Ferner seien in diesem Zusammenhang die Umsetzungsprodukte von Vinylalkohol-Polymeren mit Acryl-und/oder Methacrylsäureanhydrid erwähnt, wobei diese Umsetzungsprodukte im allgemeinen 3 bis 30 Gew.-%, bezogen auf das Umsetzungsprodukt, an Acryloyl- oder Methacryloyl-Gruppen eingebaut enthalten, als auch die wasserlöslichen Umsetzungsprodukte von Vinylalkohol-Polymeren mit Ethylenoxid bzw. Pfropfungsprodukte von Vinylalkohol(derivaten) auf Polyethylenoxid, wobei der Anteil der Ethylenoxid-Einheiten im oxethylierten Vinylalkohol-Polymer 5 bis 75 Gew.-%, insbesondere 10 bis 60 Gew.-% beträgt. Diese Umsetzungsprodukte von Vinylalkohol-Polymeren können als alleinige Polymer-Komponente in den Mischungen enthalten sein; sie können aber auch in Mischungen mit anderen Vinylalkohol-Polymeren, insbesondere den erwähnten verseiften Polyvinylestern vorliegen, wobei dann der Anteil der Umsetzungsprodukte des Polyvinylalkohols vorteilhaft 30 Gew.-%, bezogen auf die gesamten in der Mischung enthaltenen Vinylalkohol-Polymeren, oder mehr beträgt. Darüber hinaus ist es möglich, dass die genannten Vinylalkohol-Polymeren oder -Copolymeren und/oder deren Derivate mit bis zu etwa 30 Gew.-%, bezogen auf den Polymeranteil des jeweiligen photopolymerisierbaren Materials, an verträglichen Melamin-Formaldehyd-Harzen, Harnstoff-Formaldehyd-Harzen oder Phenol-Formaldehyd-Harzen abgemischt sind.

Daneben genügen als Basispolymere auch die bekannten Cellulosederivate, Gelatine, Alginat und Polyvinylpyrrolidon den gestellten Anforderungen.

Als photopolymerisierbare, ethylenisch ungesättigte Monomere für die Mischung kommen u.a. die bekannten Monomeren mit einem Molekulargewicht unter 2000 in Frage, die für polymere Bindemittel enthaltende photopolymerisierbare Materialien an sich bekannt sind, wobei sich natürlich Art und Menge der photopolymerisierbaren Monomeren nach dem mitverwendeten polymeren Bindemittel richten, mit dem sie verträglich sein sollen. Sehr geeignet sind photopolymerisierbare niedermolekulare Verbindungen mit 2 oder mehr ethylenisch ungesättigten photopolymerisierbaren Doppelbindungen allein oder deren Mischungen mit Monomeren mit nur einer olefinisch ungesättigten photopolymerisierbaren Doppelbindung, wobei der Anteil der Monomeren mit nur einer Doppelbindung von mitverwandten Polymerbindemitteln abhängt. Es ist unter bestimmten Voraussetzungen selbstverständlich möglich, als photopolymerisierbare Monomere überwiegend nur solche einzusetzen, die nur eine photopolymerisierbare Doppelbindung im Molekül enthalten, insbesondere dann, wenn das mitverwandte Polymerbindemittel selber einen hohen Anteil an photovernetzbaren Doppelbindungen enthält, wie z.B. im Fall der acryloierten und/oder methacryloierten Vinylalkohol-Polymerisate. Im allgemeinen haben die photopolymerisierbaren Monomeren einen Siedepunkt von über 100 °C bei Atmosphärendruck.

Als Beispiele für photopolymeriserbare ungesättigte niedermolekulare Verbindungen seien genannt: Mono-, Di- und Polyacrylate und -methacrylate, wie sie durch Veresterung von Acrylsäure oder Methacrylsäure mit ein- oder mehrwertigen niedermolekularen Alkoholen hergestellt werden können. Hierzu gehören u.a. die Di- und Tri-(meth)acrylate von Ethylenglykol, Diethylenglykol, Triethylenglykol, Polyethylenglykol mit einem Molekulargewicht bis zu 500, 1,2-Propandiol, 1,3-Propandiol, Polypropylenglykolen mit einem Molekulargewicht bis etwa 500, Neopentylglykol (2,2-Dimethylpropandiol), 1,4-Butandiol, 1,1,1-Trimethylpropan, Glycerin oder Pentaerythrit; ferner die Monoacrylate und Monomethacrylate solcher Diole oder Polyole, wie z.B. Ethylenglykol-mono-(meth)acrylat, 1,2-Propandiol-mono-(meth)acrylat, 1,3-Propandiol-mono-(meth)acrylat, und das Di-, Tri- oder Tetraethylenglykol-mono-(meth)acrylat. Weiterhin kommen Verbindungen in Betracht, die Urethangruppen und/oder Amidgruppen enthalten, wie die aus aliphatischen Diolen der vorstehend genannten Art, organischen Diisocyanaten, wie z.B. Hexamethylendiisocyanat, Toluylendiisocyanat und Isophorondiisocyanat, und Hydroxyalkyl-(meth)acrylaten der oben genannten Art hergestellten niedermolekularen Verbindungen. Genannt seien ferner auch Acrylsäure, Methacrylsäure, (Meth)acrylate von Alkanolen mit 1 bis 6 C-Atomen, Mono- und Bis-(meth)acrylamide von aliphatischen oder aromatischen Diaminen mit 2 bis 8 C-Atomen, wie von Ethylendiamin, Propylendiamin, Butylendiamin, Pentamethylendiamin, Hexamethylendiamin, Octamethylendiamin oder Xylylendiamin als auch Derivate der (Meth)acrylamide, z.B. Hydroxymethyl-(meth)acrylamid, oder insbesondere die Umsetzungsprodukte von 2 Mol N-Hydroxymethyl-(meth)acrylamid mit einem Mol des aliphatischen Diols, z.B. Ethylenglykol oder Propylenglykol.

Die Auswahl der geeigneten Monomeren richtet sich nach den mitverwendeten Polymerbindemitteln und nach den angestrebten Eigenschaften des Endproduktes und ist dem Fachmann geläufig. Werden als Polymerbindemittel Vinylalkoholpolymerisate eingesetzt, eignen sich als Monomere besonders die wasserlöslichen Monomere, wie z.B. die Hydroxyalkyl-(meth)acrylate, die Mono-oder Di-(meth)acrylate von Polyethylenglykolen oder Mischungen hiervon mit Di- oder Poly-(meth)acrylaten der oben genannten Art.

Die photopolymerisierbaren Mischungen enthalten die Polymeren und die photopolymerisierbaren ethylenisch ungesättigten Monomeren im allgemeinen in einer Menge von etwa 50 bis 90 Gew.-% bzw. von 10 bis 50 Gew.-% jeweils bezogen auf die Summe von Polymeren und Monomeren. Der Anteil der Monomeren kann in einzelnen Fällen auch grösser oder kleiner sein. So ist es beispielsweise möglich, den Anteil der Monomeren unter 10 Gew.-% abzusenken, wenn in den Mischungen ungestättigte Polymere mit einem hinreichend hohen Gehalt an photovernetzbaren Doppelbindungen enthalten sind.

Als Photopolymerisationsinitiatoren, die in den Mischungen im allgemeinen in Mengen von 0,05 bis 10 Gew.-% und insbesondere von 0,5 bis 5 Gew.-%, bezogen auf die Mischung, enthalten sind, kommen die bekannten und üblichen Photopolymerisationsinitiatoren und Systeme für die Auslösung einer Photopolymerisation bei Bestrahlung mit aktinischem Licht in Frage, wie sie hinreichend in der einschlägigen Fachliteratur beschrieben sind. Genannt seien z.B. Acyloine und deren Derivate, wie Benzoin, Benzoinalkylether, z.B. Benzoinmethylether oder Benzoinisopropylether, α-Methylolbenzoin und dessen Ether oder α-Methylbenzoin und dessen Ether; 1,2-Diketone und deren Derivate wie Diacetyl, Benzil, Benzilketale wie Benzildimethylketal, Benzilmethylethylketal, Benzilmethylbenzylketal oder Benzylethylenglykol-monoketal; Acylphosphinoxid-Verbindungen, insbesondere Acyl-diarylphosphinoxide und speziell Acyl-diphenylphosphinoxide, deren Acylrest sich von einer tertiären aliphatischen oder cycloaliphatischen Carbonsäure oder von einer mindestens in 2,6-Stellung substituierten Benzoesäure ableitet, wie sie in der DE-OS 29 09 992 ausführlich beschrieben sind. Die Photopolymerisationsinitiatoren können allein oder in Mischung miteinander oder auch in Mischung mit Aktivatoren, wie z.B. tertiären Aminen eingesetzt werden.

Die photopolymerisierbaren Mischungen können darüber hinaus als weitere Zusätze beispielsweise Weichmacher, Farbstoffe, Pigmente oder dergleichen enthalten.

Zum Belichten der lichtempfindlichen Aufzeichnungsmaterialien werden Lichtquellen eingesetzt, die aktinisches Licht im Wellenlängenbereich von im allgemeinen 250 bis 500 nm, vorzugsweise im Bereich von 300 bis 450 nm auszustrahlen vermögen und deren Emissionsmaxima im allgemeinen im Bereich der Absorption der Photoinitiatoren liegen.

Die mit den hochempfindlichen photopolymerisierbaren Mischungen gewinnbaren Elemente können – je nach Zusammensetzung – für die verschiedensten Zwecke, vor allem für die Informationsverarbeitung verwendet werden. So lassen sich Informationen in direkt lesbarer oder digitaler Form einschreiben, reproduzieren und gegebenenfalls auf andere Informationssysteme übertragen. Als praktische Anwendungen kommen in Frage die Herstellung von Mustern und Resists für elektrische Leitungssysteme und verwandte Anwendungen, die Erzeugung von Oberflächenmustern und Reliefs, Schichten für Schwarzweiss- und Farbfilme, Druckplatten für Hochdruck, Offsetdruck, Tiefdruck, Siebdruck und zur Abformung von Duplikatdruckformen, die Abbildungen für Farbprüfverfahren, und andere reprographische Zwecke, Materialien für die Archivierung von Bild- und Textinformationen, für die Herstellung von Listen und Verzeichnissen.

Die Dicke der lichtempfindlichen Schicht ist in weiten Grenzen je nach Anwendungszweck variierbar. Selbstverständlich können auch Mehrschichtsysteme hergestellt werden. In den meisten Fällen wird die photopolymerisierbare Mischung auf einen Träger aufgebracht, der auf die vorgesehene Verwendung abgestimmt ist, z.B. Metall, Kunststoff, Papier; auch keramische Massen und Halbleitermaterialien kommen in Betracht.

Das erfindungsgemässe Verfahren erlaubt, photopolymerisierbare Mischungen bereitzustellen, welche neben der erhöhten Empfindlichkeit und der hohen Auflösung bei der Informationsverarbeitung eine beträchtlich verbesserte Stabilität gegen thermische Polymerisation sowohl bei Raumtemperatur als auch bei Temperaturen bis zu 100 °C aufweisen. Der Zeitraum, während dessen bei thermischer oder auch andersartiger Belastung keine spontane Polymerisation auftritt, ist häufig auf das 2- bis 10-fache verlängert. In manchen Fällen werden hochempfindliche Mischungen durch die erfindungsgemässe Stabilisierung überhaupt erst technisch handhabbar.

Die nachstehenden Beispiele und Vergleichsversuche erläutern die Erfindung. Die in den Beispielen und Vergleichsversuchen angegebenen Teile beziehen sich, sofern nicht anders angegeben, auf das Gewicht.

Beispiel 1

67,5 Teile eines Polyvinylpyrrolidons des Molekulargewichtes 600 000 bis 800 000 (K-Wert 92) werden bei 90 °C in 400 Teilen vollentsalztem Wasser gelöst. Anschliessend werden 0,05 Teile der Additionsverbindung von Kaliumjodid und Jod (Molverhältnis etwa 1:1) eingerührt. Nach dreistündiger Einwirkungszeit bei 70 °C werden 30 Teile des Diethers aus 1 Mol Ethylenglykol und 2 Molen N-Hydroxymethylacrylamid, 0,1 Teil N-Nitrosocyclohexylhydroxylamin und 2,5 Teile α-Methylolbenzoinmethylether hinzugefügt. Sobald alle Bestandteile gelöst sind, wird die Ansatzlösung filtriert, unter vermindertem Druck entgast und für die Herstellung lichtempfindlicher Elemente verwendet.

Eine Probe wird einem Stabilitätstest in einer verschlossenen Ampulle unter Ausschluss aktinischer Strahlung bei 80 °C unterworfen: Sie bleibt über 70 Stunden unverändert, während eine nicht erfindungsgemäss behandelte Mischung bereits nach 6 Stunden erstarrt. Der Stabilitätsfaktor beträgt somit > 11.

Beispiel 2

Die Behandlung der Polyvinylpyrrolidonlösung erfolgt in Abwandlung des Beispiels 1 mit 0,25% eines handelsüblichen Komplexes aus Polyvinylpyrrolidon und Jod (Jodanteil 11 bis 12%) während 8 Stunden bei 80 °C. Im übrigen wird wie in Beispiel 1 verfahren.

Der Stabilitätstest (80 °C) verläuft wie beim Beispiel 1, d.h. Stabilitätsfaktor > 11.

Beispiel 3

Die Polyvinylpyrrolidonlösung analog Beispiel 1 wird 3 Stunden mit 0,03 Teilen Jod bei 60 °C behandelt. Im übrigen wird wie in Beispiel 1 verfahren.

Die Stabilität der so erhaltenen photopolymerisierbaren Mischung ist um den Faktor 4 erhöht.

Beispiel 4

68 Teile eines N-Vinylpyrrolidon/Vinylacetat-Copolymerisats (Gew.-Verh. 60:40) mit einem K-Wert von 32 werden in 67 Teilen vollentsalztem Wasser bei 70 °C gelöst. Hierauf wird bei der selben Temperatur 3 Stunden mit 0,25 Teilen eines Komplexes aus Polyvinylpyrrolidon und Jod (Jodanteil 11 bis 12%) behandelt. Sodann werden 25 Teile 2-Hydroxyethylmethacrylat, 5 Teile Trimethylolpropantriacrylat, 2,0 Teile Benzildimethylketal und 0,02 Teile N-Nitrosodiphenylamin eingerührt. Die Lösung wird filtriert, unter vermindertem Druck entgast und für die Gewinnung lichtempfindlicher Schichten verwendet.

Beim Stabilitätstest (80 °C, verschlossene Ampulle) scheiden sich nach 55 Stunden aus der sonst unveränderten Lösung die ersten feinen popcornartigen Polymerisatteilchen ab; sie nehmen nur langsam zu. In einem unbehandelten Vergleichsansatz hingegen wird schon nach 18 Stunden deutliche, rascher zunehmende Polymerisatbildung beobachtet. Der Stabilitätstest beträgt somit 3.

Beispiel 5

In Abwandlung des vorstehenden Beispiels wird die Lösung des Copolymerisats mit 0,005 Teilen der Additionsverbindung von Kaliumjodid und Jod (Molverhältnis etwa 1:1) behandelt. Die Einwirkungszeit beträgt 4 Stunden bei 70 °C. Hierauf wird wie in Beispiel 4 weitergearbeitet.

Die Stabilität der so erhaltenen photopolymerisierbaren Mischung ist um den Faktor 1,7 erhöht.

Beispiel 6

Es wird wie in Beispiel 5 verfahren, lediglich die Menge des für die Behandlung der Copolymerisatlösung verwendeten Kaliumjodid/Jod-Addukts wird auf 0,05 Teile erhöht. Der Stabilitätsfaktor steigt auf 2,3.

Beispiel 7

Unter Beibehaltung der Mengen von Beispiel 6 wird die Behandlung der Copolymerisatlösung aus dem Kaliumjodid/Jod-Addukt während 24 Stunden bei 40 °C durchgeführt. Der Stabilitätsfaktor beträgt nun 2,7.

Beispiel 8

328 Teile eines teilverseiften Polyvinylacetats (Verseifungsgrad 82 Mol.-%; mittlerer Polymerisationsgrad 500) werden in 294 Teilen vollentsalztem Wasser bei 90 °C gelöst. Hierauf wird die Lösung nach Zugabe von 2,5 Teilen eines Komplexes aus Polyvinylpyrrolidon und Jod (Jodanteil 11 bis 12%) 4 Stunden bei 70 °C gerührt. Dann werden 51 Teile Butandiol-1,4-dimethacrylat, 9,6 Teile Benzildimethylketal und 1,0 Teile 2,6-Di-tert.-butyl-p-kresol gelöst in 241 Teilen β-Hydroxyethylmethacrylat, ebenfalls unter Rühren hinzugefügt. Die homogene Lösung wird filtriert und bei vermindertem Druck entgast. Durch Beschichten geeigneter Träger werden lichtempfindliche Verbundelemente erhalten.

Beim Stabilitätstest der Lösung in einer verschlossenen Ampulle bei 80 °C wurden erst nach 70 Stunden die ersten Polymerisatteilchen beobachtet; ein unbehandelter Vergleichsansatz polymerisierte bereits nach 32 Stunden. Der Stabilitätsfaktor beträgt also 2,2.

Beispiel 9

39,5 Teile eines teilverseiften Polyvinylacetats (Verseifungsgrad 80 Mol-%; mittlerer Polymerisationsgrad 500) werden in 40 Teilen vollentsalztem Wasser bei 90 °C gelöst. Nach Abkühlen auf 70 °C werden 9,9 Teile eines teilverseiften Polyvinylacetats, das 22% $CH_2$–$CH_2$–O-Einheiten gebunden enthält (mittleres Molekulargewicht 25 000 bis 30 000), unter Rühren hinzugegeben. Die so erhaltene homogene Lösung wird sodann mit 0,05 Teilen der Additionsverbindung von Kaliumjodid und Jod (Molverhältnis etwa 1:1) 3 Stunden bei 70 °C behandelt. Hierauf wird eine Lösung von 7,6 Teilen Butandiol-1,4-dimethacrylat, 0,5 Teilen 2,4,6-Trimethylbenzoyldiphenylphosphinoxyd, 0,15 Teilen 2,6-Di-tert.-butyl-p-kresol und 0,02 Teilen N-Nitrosodiphenylamin in 42 Teilen β-Hydroxyethylmethacrylat eingerührt. Die Ansatzlösung wird dann filtriert und entgast und zu lichtempfindlichen Elementen verarbeitet. Der nach dem selben Verfahren wie bei Beispiel 8 bestimmte Stabilitätsfaktor beträgt 1,9.

Beispiel 10

Beispiel 9 wird variiert durch Verwendung von 0,25 Teilen (statt 0,05 Teilen) der Additionsverbindung von Kaliumjodid und Jod. Alle übrigen Rezepturbestandteile bleiben unverändert. Der Stabilitätstest ergibt nun den Faktor 2,7.

Beispiel 11

18 Teile eines teilverseiften Polyvinylacetats (Verseifungsgrad 80 Mol.-%; mittleres Molekulargewicht 30 000 bis 35 000) und 18 Teile eines teilverseiften Polyvinylacetats (Verseifungsgrad 88 Mol.-%; mittleres Molekulargewicht 30 000) werden durch mehrstündiges Rühren in 40 Teilen vollentsalztem Wasser bei 90 °C gelöst. Nach Abkühlen auf 70 °C werden 18 Teile eines teilverseiften Polyvinylacetats, das 22% $CH_2$–$CH_2$–O-Einheiten gebunden enthält (mittleres Molekulargewicht 25 000 bis 30 000), unter Rühren hinzugegeben. Die so erhaltene homogene Polymerlösung wird dann ebenfalls unter Rühren 3 Stunden bei 80 °C mit 0,3 Teilen der Additionsverbindung von Kaliumjodid und Jod behandelt. Hierauf wird die Lösung von 3 Teilen Tetraethylenglykoldimethylacrylat, 1,7 Teilen Benzildimethylketal, 0,15 Teilen 2,6-Di-tert.-butyl-p-kresol, 0,03 Teilen N-Nitrosocyclohexylhydroxylamin und 0,003 Teilen Eosin in 40 Teilen β-Hydroxyethylmethacrylat hinzugefügt und homogenisiert. Nach Filtration und Entgasung unter vermindertem Druck wird die photopolymerisierbare Ansatzlösung zur Herstellung lichtempfindlicher Elemente verwendet. Der Stabilitätstest bei 80 °C ergab einen Faktor von 2,3.

**Patentansprüche**

1. Verfahren zur Stabilisierung von photopolymerisierbaren, wasserlöslichen oder wasserdispergierbaren Mischungen, im wesentlichen bestehend aus einem Basispolymerisat, mindestens einer polymerisierbaren ethylenisch ungesättigten Verbindung und mindestens einem Photoinitiator und/oder Photosensibilisator, gegen die thermische Polymerisation, dadurch gekennzeichnet, dass das Basispolymerisat allein oder zusammen mit den anderen Komponenten der photopolymerisierbaren Mischung mit einem Halogen, einem Pseudohalogen oder einem Polyhalogenid, dessen komplexes Anion als das Anlagerungsprodukt von freiem Halogen an ein Halogenidion anzusehen ist, behandelt wird.

2. Verfahren nach Anspruch 1, dadurch gekennzeichnet, dass man die Behandlung in Gegenwart von Wasser oder in wässriger Lösung bei einer Temperatur zwischen 20 und 100 °C durchführt.

**Revendications**

1. Procédé pour la stabilisation, à l'égard de la polymérisation thermique, de mélanges photopolymérisables, solubles ou dispersables dans l'eau, constitués essentiellement d'un polymérisat de base, d'au moins un composé insaturé éthyléniquement, polymérisable et d'au moins un photoinitiateur et/ou photosensibilisateur, caractérisé par le fait que le polymérisat de base, seul ou avec les autres composants du mélange photopolymérisable, est traité avec un halogène, un pseudohalogène ou un polyhalogénure, dont l'anion complexe est à considérer comme le produit d'addition d'halogène libre sur un ion halogénure.

2. Procédé selon la revendication 1, caractérisé par le fait que l'on effectue le traitement à une température comprise entre 20 et 100 °C, en présence d'eau ou en solution aqueuse.

**Claims**

1. A process for stabilizing a photopolymerizable water-soluble or water-dispersible mixture, consisting essentially of a base polymer, at least one polymerizable ethylenically unsaturated compound and at least one photoinitiator and/or photosensitizer, against thermal polymerization, wherein the base polymer, alone or together with the other components of the photopolymerizable mixture, is treated with a halogen, a pseudohalogen or a polyhalide whose complex anion is to be regarded as the adduct of free halogen with a halide ion.

2. A process as claimed in claim 1, wherein the treatment is carried out in the presence of water or in aqueous solution at from 20 to 100 °C.